Europäisches Patentamt

European Patent Office

Office européen des brevets

(11) Publication number: **0 046 013**
**B1**

(12) **EUROPEAN PATENT SPECIFICATION**

(45) Date of publication of patent specification: **15.10.86**

(51) Int. Cl.⁴: **G 11 C 19/08, H 02 M 3/335**

(21) Application number: **81303186.1**

(22) Date of filing: **13.07.81**

(54) Power source device for a bubble memory unit.

(30) Priority: **14.07.80 JP 95975/80**

(43) Date of publication of application:
**17.02.82 Bulletin 82/07**

(45) Publication of the grant of the patent:
**15.10.86 Bulletin 86/42**

(84) Designated Contracting States:
**DE FR GB**

(56) References cited:
**EP-A-0 023 124**
**FR-A-2 339 905**
**US-A-4 117 544**

**Elektronik, Vol. 21, No. 9, Sept 72, pages 295-297**

(73) Proprietor: **FANUC LTD**
**3580, Shibokusa Aza-Komanba Oshino-mura Minamitsuru-gun Yamanashi 401-05 (JP)**

(72) Inventor: **Imazeki, Ryoji**
**987-44, Naganuma-cho, Hachioji-shi Tokyo (JP)**
Inventor: **Hattori, Masayuki**
**1271-41, Narahara-cho, Hachioji-shi Tokyo (JP)**
Inventor: **Nakamura, Shigeo**
**5540, Hino, Hino-shi Tokyo (JP)**

(74) Representative: **Billington, Lawrence Emlyn et al**
**HASELTINE LAKE & CO Hazlitt House 28 Southampton Buildings Chancery Lane London WC2A 1AT (GB)**

Courier Press, Leamington Spa, England.

## Description

This invention relates to a power source device in combination with a bubble memory unit.

Such a power source device is disclosed in EP—A—23 124 published on 28.01.1981.

A bubble memory unit is a so-called nonvolatile memory unit whose stored content is held even after the disconnection of a power supply. Therefore, it has heretofore been used in electronic computers and has recently come into use in the data memory devices of numerical control systems. A bubble memory unit includes a bubble memory part in which information is stored, and a control part which controls the writing and reading of information into and from the bubble memory part, etc. The bubble memory part and the control part are connected with a power source device which is provided for the bubble memory unit. The power source device delivers a memory enable signal (signal $M_e$) which establishes conditions for permitting the control part to transmit read and write instructons to the bubble memory part, a controlling supply voltage (supply voltage $E_c$) which is applied to both the bubble memory part and the control part, and a driving supply voltage (supply voltage $E_d$) which serves to drive the bubble memory part.

As common examples for turning "on" or "off" such a power source device, there may be cited (1) a case where a commercial power supply is employed and where the output of the power source device is turned "on" or "off" by a power switch disposed within the power source device and (2) a case where no separate power switch is provided and where the switching-on or off of a commercial power supply is relied on. In either case, the signal $M_e$ and the supply voltages $E_c$ and $E_d$ must be applied or cut off in a predetermined sequence. More specifically, when the bubble memory unit is energized, the supply voltage $E_c$, the supply voltage $E_d$ and the signal $M_e$ must be applied in the order mentioned, and when the bubble memory unit is deenergized, they must be cut off in the reverse order. Especially in the case of deenergizing the bubble memory unit, that period of time after the cutoff of the signal $M_e$ in which the supply voltage $E_d$ lowers to a predetermined value needs to be at least several milliseconds, and besides, the supply voltage $E_c$ must hold a predetermined value during the period. If the period of time of the order of several milliseconds shortens, a memory refresh operation in which information being read is rewritten into the bubble memory part will not be perfectly or completely executed and the stored information will be lost. In this regard, a prior-art power source device is not guaranteed to make the period of time several milliseconds or longer without fail. Therefore, one prevents the disappearance of information by, for example, installing a backing-up power source separately. For this reason, the prior-art power source device for a bubble memory unit has the disadvantages of being large in size and being high in production cost.

EP—A—23 124 was published on 28 January 1981 and discloses a power source device for a bubble memory unit in which $M_e$, $E_c$ and $E_d$ must be applied and cut-off in a predetermined sequence which is the same as in the present application, $E_c$ and $E_d$ being obtained from power supplies of a switching type like in the present application.

FR—A—2 339 905 discloses a power supply circuit in which a pulse signal supplied to a switching element is increased in pulse width when the input voltage drops.

The article by Haseloff published in Elektronik, volume 21, number 9, September 1972, pages 295—297 discloses the same raising sequence for a dual power supply circuit and a rapid discharge circuit for one of them.

According to the present invention there is provided a power source device in combination with a bubble memory unit comprising a bubble memory part and a control part, the power source device being operable to produce a supply voltage ($E_c$) for controlling the bubble memory part and the control part together constituting the bubble memory unit as aforesaid, a supply voltage ($E_d$) for driving the bubble memory part, and a memory enable signal ($M_e$) to be applied to the control part, the bubble memory unit being of a type in which a refresh operation can be completed even if the memory enable signal ($M_e$) has been removed, and the power source device being operable on switch-on to produce voltages in the sequence $E_c$, $E_d$, $M_e$, and on switch-off to cancel them in the reverse sequence, and comprising a stabilised D.C. power source circuit for producing the controlling supply voltage ($E_c$) and a switching circuit for producing the driving supply voltage ($E_d$) in dependence upon the value of the controlling supply voltage ($E_c$), the stabilised D.C. power source circuit employing a switching voltage regulator utilising chopping pulses and a circuit for expanding a chopping pulse width in excess of its upper-limit width value during an ordinary voltage control, in circumstances such that when an output voltage value of said controlling supply voltage ($E_c$) becomes lower than a predetermined value, said chopping pulse width becomes greater by said expanding circuit than in said ordinary voltage control, thereby to provide that the controlling supply voltage ($E_c$) and consequently the driving supply voltage ($E_d$) are maintained sufficiently to provide that a memory refresh operation may be properly excuted after said power source device for said bubble memory unit has been turned-off, the expanding circuit being arranged to operate in dependence upon a signal from a latch circuit at the output of a comparator which detects the lowering of said controlling supply voltage ($E_c$) below said predetermined value.

A preferred embodiment provides a power source device having a plurality of supply voltage or signal output terminals in which, in energizing or deenergizing the power source device, output signals at the output terminals can be turned "on" or "off" in a prescribed sequence and at predetermined time intervals.

Moreover, the preferred embodiment provides a power source device for a bubble memory unit in which, especially in turning "off" outputs of the power source device, the period of time in which a supply voltage $E_c$ applied to a bubble memory part lowers to its service lower-limit value after a memory enable signal $M_e$ applied to a control part has turned "off" can be held for at least several milliseconds.

The preferred embodiment further provides a power source device in which, even when a commercial power supply applied to the power source device is unexpectedly interrupted, the refresh operation for the bubble memory part is completely carried out.

The present invention will be more clearly understood by referring to the following detailed description when considered in conjunction with the accompanying drawings wherein:

Figure 1 is a block diagram of a general bubble memory unit provided with a power source device;

Figure 2 is a waveform diagram of supply voltages and a signal which are applied to predetermined parts of the bubble memory unit;

Figure 3 is a block diagram showing an embodiment of the present invention;

Figure 4 is a block diagram showing a stabilized D.C. power source circuit which is disposed in the power source device shown in Figure 3; and

Figure 5 is a waveform diagram showing voltage waveforms at various positions in the embodiment of this invention.

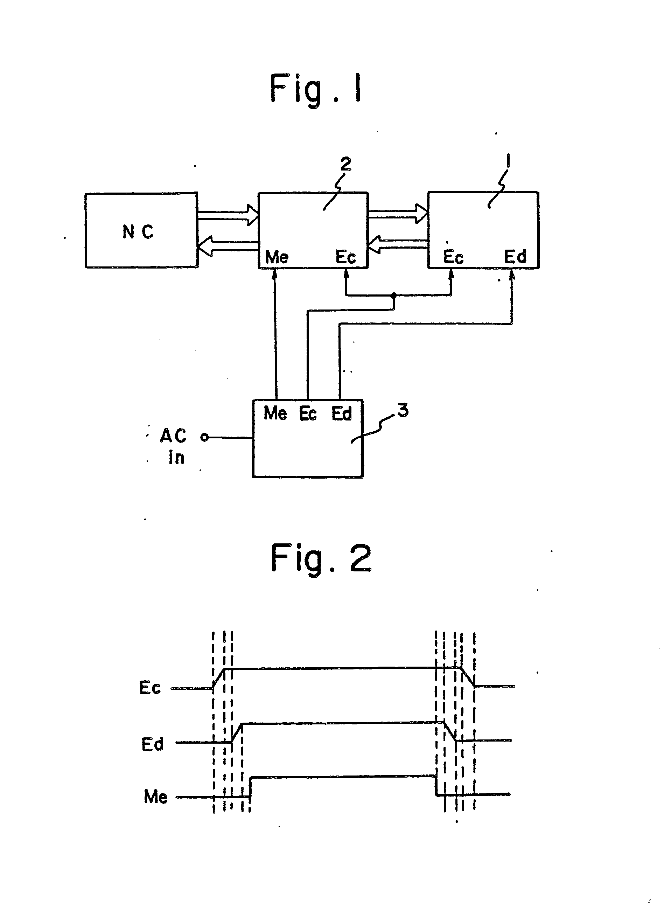

Figure 1 is a block diagram of a bubble memory unit provided with a power source device. Referring to the figure, numeral 1 designates a bubble memory part, and numeral 2 a control part which controls the writing and reading of information into and from the bubble memory part 1, etc. The control part 2 also exchanges information with a numerical control system NC. A power source device 3 feeds supply voltages and a signal to the bubble memory part 1 and the control part 2 which constitute the bubble memory unit. That is, the power source device 3 delivers the supply voltages $E_c$ and $E_d$ and the signal $M_e$. The supply voltage $E_c$ serves to control the bubble memory part 1 and the control part 2, while the supply voltage $E_d$ serves to drive the bubble memory part 1. The signal $M_e$ is a signal which establishes a condition for permitting the control part 2 to transmit the instruction of reading or writing the information to the bubble memory part 1, and it is a type of enable signal.

Figure 2 shows the waveforms of the outputs of the power source device 3 in the case where the bubble memory unit consisting of the bubble memory part 1 and the control part 2 is energized and in the case where it is deenergized. In either case, the supply voltage $E_c$, supply voltage $E_d$ and signal $M_e$ must be applied from the power source device 3, and cut-off, in a sequence illustrated in Figure 2. Especially in the case of deenergizing the power source device 3, that period of time after the cutoff of the signal $M_e$ in which the

supply voltage $E_c$ applied to the bubble memory part 1 lowers to the required minimum voltage value can be made at least several milliseconds without fail in accordance with the present invention.

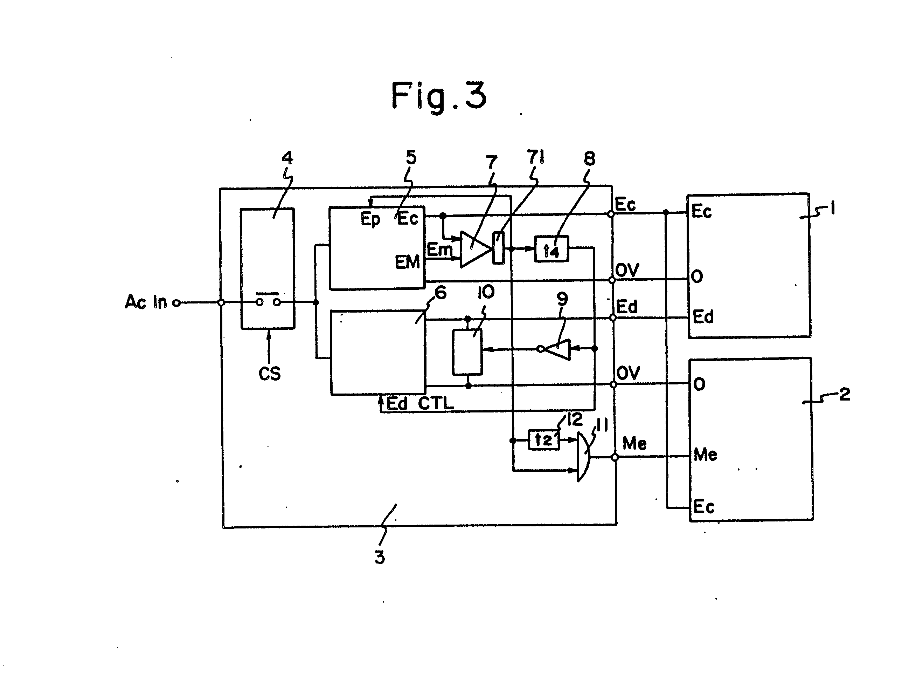

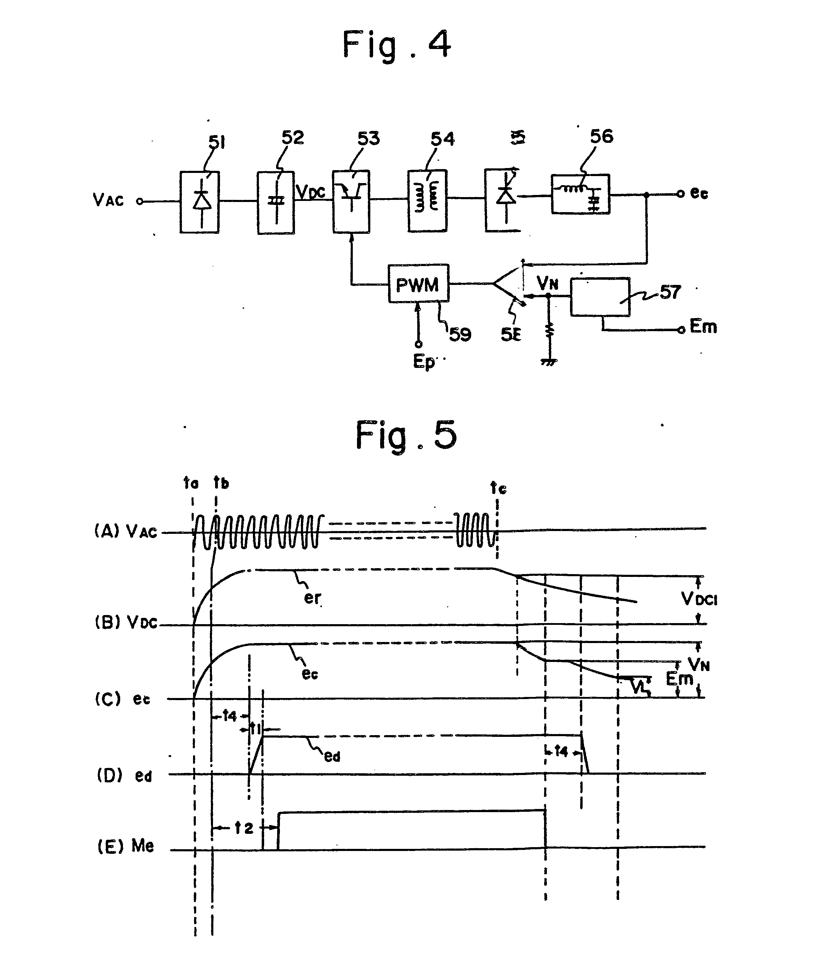

Figure 3 is a detailed block diagram including an embodiment of this invention. In the figure, parts 1 through 3 are the same as in Figure 1. In the present power source device 3 which is in accordance with the present invention, numeral 4 indicates a power source switch circuit. The power source switch circuit 4 is connected to a commercial power supply. It is turned "on" by a control signal CS which is transmitted from equipment employing the bubble memory unit, such as a numerical control system or an electronic computer, and it is turned "off" when the control signal CS is cut off. Numeral 5 indicates a stabilized D.C. power source circuit. The stabilized D.C. power source circuit 5 is of the switching regulator type based on pulse width modulation, and delivers the supply voltage $E_c$ and a reference voltage $E_m$. Now, the arrangement of the stabilized D.C. power source circuit 5 will be described with reference to Figure 4. In the figure, numeral 51 designates a rectifier, which is usually constructed by connecting silicon rectifier elements in a bridge circuit. In this embodiment, the commercial A.C. voltage is directly rectified. However, when the commercial supply voltage is high according to the practice of a country, or when it is inconvenient to directly connect the power source device 3 and the commercial power supply by the use of a conductor, a transformer may be interposed between the commercial power supply and the rectifier 51. Numeral 52 indicates a smoothing capacitor, numeral 53 a switching element which is a transistor, numeral 54 a transformer, numeral 55 a rectifier similar to the rectifier 51, and numeral 56 a low-pass filter which consists of a choke coil and a capacitor. Shown at 57 is a reference voltage source which serves to deliver the reference voltage $E_m$ and which also delivers a voltage $V_N$ that is applied to an error amplifier 58 to be described later. The reference voltage source 57 has charge storing means such as a capacitor of large capacitance, so that even when the commercial power supply is interrupted, the source 57 can continue to provide the correct reference voltage $E_m$ and correct voltage $V_N$ as predetermined for at least scores of milliseconds owing to the discharge of the charge storing means. The error amplifier 58 has its one output terminal supplied with the output of the low-pass filter 56, and has the other input terminal supplied with the voltage $V_N$. Shown at 59 is a pulse width modulation circuit. The pulse width modulation circuit 59 is provided with a dead time setting terminal $E_p$. When a signal "1" is applied to the dead time setting terminal $E_p$, a signal pulse whose duty is subjected to pulse width modulation up to at most 30% is delivered. On the other hand when a signal "0" is applied, a signal pulse whose duty is subjected to pulse width modulation up to at most 45% is delivered. Now, the operation of the stabilized D.C. power source circuit 5 will be briefly described. The alternating current applied through the power source switch circuit 4 is rectified by the rectifier 51 into direct current. The D.C. voltage as smoothed by the smoothing capacitor 52 is chopped by the switching element 53 which is controlled by the control pulse generated from the pulse width modulation circuit 59. The chopped voltage is turned by the transformer 54 into A.C. voltage, which is rectified by the low-pass filter 56. Thus, a D.C. voltage to be used as the supply voltage $E_c$ is delivered from an output terminal $e_c$. The error amplifier 58 compares this output voltage with the reference voltage $V_N$. Where the output voltage is lower than the reference voltage $V_N$, the error amplifier 58 makes great the width of the signal pulse to be provided from the pulse width modulation circuit 59, so as to bring the output voltage into agreement with the reference voltage $V_N$. In the converse case, it makes the width of the signal pulse small so as to bring the output voltage into agreement with the reference voltage $V_N$. Referring back to Figure 3, numeral 6 is a stabilized D.C. power source circuit for the supply voltage $E_d$. The stabilized power source circuit 6 includes a rectifier circuit therein. It is so constructed that an applied alternating current is rectified by the rectifier circuit into direct current and that an output voltage can be increased or decreased by the use of a control element which is made of a power transistor. It is internally provided with a circuit for comparing the output voltage with a reference voltage. Where the output voltage is going to become higher than the reference voltage, the resistance component of the control element is increased, and where the output voltage is going to become lower than the reference value, the resistance component of the control element is decreased, whereby the output voltage can follow up the reference voltage at all times. When an enable signal $E_d$ CTL is "1", the supply voltage $E_d$ for the bubble memory part 1 is delivered, and when it is "0", the supply voltage $E_d$ is not delivered. Shown at 7 is a comparator which compares the reference voltage $E_m$ and the supply voltage $E_c$ which are provided from the stabilized D.C. power source circuit 5. A latch circuit 71 latches a signal which is delivered from the comparator 7. When the output of the comparator 7 having been "0" at the closure of the power supply has become "1", the latch circuit 71 latches and provides the output "1". As soon as the output of the comparator 7 has thereafter become "0", it latches the output "0". Even when the output of the comparator 7 has thereafter become "1", it continues to latch "0". Numeral 8 indicates a delay circuit, the delay time of which is several milliseconds. Numeral 9 indicates an inverter, and numeral 10 a rapid discharge circuit which is usually constructed of a thyristor. Numeral 11 indicates an AND circuit, and numeral 12 a delay circuit.

Now, the operation of the circuit arrangement shown in Figure 3 will be described.

When, in order to actuate the numeral control system by way of example, a power source switch of the NC system is closed at a time $t_a$ indicated in Figure 5, the control signal CS from the system NC becomes its high level and closes the power source switch circuit 4. Upon the closure of the power source switch circuit 4, an A.C. voltage as shown at (A) of Figure 5 is applied to the stabilized D.C. power source circuit 5 for the supply voltage $E_c$, and the stabilized D.C. power source circuit 6 for the supply voltage $E_d$. The A.C. voltage is rectified in the two circuits 5 and 6. The reference voltage $E_m$ shown in (C) of Figure 5 is immediately delivered from the terminal $E_m$ of the stabilized D.C. power source circuit 5. Simultaneously therewith, a voltage is generated at the terminal $e_c$. This output voltage rises gradually as shown in (C) of Figure 5. In the comparator 7, the voltage $e_c$ and the reference voltage $E_m$ are compared. When the voltage $e_c$ < the reference voltage $E_m$ holds, the output of the comparator 7 is "0". Accordingly, the enable signal $E_d$ CTL of the stabilized D.C. power source circuit 6 for the supply voltage $E_d$ is "0", and no voltage is provided from the circuit 6. When the voltage $e_c$ has gradually risen to exceed the reference voltage $E_m$ at a time $t_b$, the output of the comparator 7 becomes "1", and the latch circuit 71 immediately latches it and provides "1". When a period of time $t_4$ has subsequently lapsed, the output of the delay circuit 8 becomes "1". Therefore, the output of the inverter 9 becomes "0", and the rapid discharge circuit 10 holds its disabled state. When the output of the delay circuit 8 has become "1", the stabilized D.C. power source circuit 6 for the supply voltage $E_d$ starts its operation because the enable signal $E_d$ CTL is now "1". A voltage $e_d$ corresponding to the supply voltage $E_d$ rises comparatively fast, and reaches a prescribed value in a period of time $t_1$. Upon lapse of a period of time $t_2$ after the time $t_b$ at which the voltage of the comparator 7 has become "1", the output of the delay circuit 12 becomes "1". Therefore, the output of the AND circuit 11 becomes "1", the memory enable signal $M_e$ becomes "1", and the bubble memory unit becomes usable. As is apparent from Figure 5, the delay time $t_2$ of the delay circuit 12 is set so as to be $(t_1 + t_4) < t_2$.

Now, there will be described a case where the power source switch circuit 4 has been opened or where the A.C. input end has ben erroneously disconnected. When the A.C. power supply has been disconnected at a time $t_c$ in Figure 5, the A.C. supply voltage to the stabilized D.C. power source circuit 5 for the supply voltage $E_c$, and the stabilized D.C. power source circuit 6 for the supply voltage $E_d$ is cut off ((A) of Figure 5). Therefore, the D.C. output voltages of the rectifier circuits contained in the two circuits 5 and 6 lower gradually. Since capacitors are connected on the output sides of these two circuits, the output voltages do not lower rapidly. (B) of Figure 5 shows the output voltage $e_r$ of the rectifier 51 of the stabilized D.C. power source circuit 5 for the supply voltage $E_c$. when this voltage has lowered to a value $V_{DC1}$, the quantity of charge in the capacitor of the low-pass filter 56 is small, and the output voltage $E_c$ of the stabilized D.C. power source circuit 5 cannot maintain the voltage $V_N$ and begins to lower with the lowering of the output voltage of the rectifier 51. When the voltage $E_c$ has become lower than the voltage $E_m$, the output of the comparator 7 becomes "0", and hence, the output of the latch circuit 71 becomes "0". In consequence, one input terminal of the AND circuit 11 becomes "0", and the signal $M_e$ immediately becomes "0". Acordingly, the exchange of information between the interior and exterior of the bubble memory unit is inhibited entirely. When the output of the latch circuit 71 has become "0", the dead time setting terminal $E_p$ of the stabilized D.C. power source circuit 5 for the supply voltage $E_c$ becomes "0". Therefore, the duty of the control pulse is expanded to 45%, and the output voltage does not become lower than the voltage $E_m$ for a while under the action of the control pulse in the direction of bringing of the output voltage closer to the voltage $V_N$. However, the quantities of charge stored in the smoothing capacitor 52 in the stabilized D.C. power source circuit 5 for the supply voltage $E_c$ and the capacitor in the low-pass filter 56 become small, and the output voltage $E_c$ cannot maintain the value $E_m$ in spite of the widening of the control pulse and gradually lowers toward the lowest service voltage $V_L$. Meantime, both the supply voltage $E_c$ and the supply voltage $E_d$ are at the lowest operating voltages or above. Therefore, the bubble memory part 1 and the control part 2 operate perfectly, and the information read out from the bubble memory part 1 is written thereinto again to complete a refresh operation. On the other hand, upon lapse of the period of time $t_4$ or several milliseconds after the time when the output of the latch circuit 71 has changed-over from "1" to "0", the output of the delay circuit 8 becomes "0". Accordingly, the enable signal $E_d$ CTL becomes "0", so that the stabilized D.C. power source circuit 6 for the supply voltage $E_d$ falls into its inoperative state. Simultaneously, the rapid discharge circuit 10 falls into its conductive state to short-circuit its output ends, and the supply voltage $E_d$ rapidly becomes "0". The output voltage $e_c$ of the stabilized D.C. power source circuit 5 for the supply voltage $E_c$ still continues to lower gradually. In a short time after lapse of the period of time $t_4$, the voltage becomes lower than the allowable lower-limit voltage $V_L$.

In the above embodiment, where an overvoltage protection circuit called a clover circuit is disposed within the stabilized D.C. power source circuit 6 for the supply voltage $E_d$, it can also be used as the rapid discharge circuit 10.

As described above in detail, according to general principles the power source circuit for the control circuit is constructed on the basis of the pulse width modulation system, and upon interruption of the A.C. input voltage, the duty cycle can be set to an upper limit greater than that employed during ordinary use, so that the period of time in which the control voltage reaches the allowable lower-limit voltage after the interruption of the A.C. input voltage can be made longer than in the prior art. Accordingly, even when the A.C. input voltage is unexpectedly interrupted due to service interruption or the like in the course of reading information stored in the bubble memory, a refresh operation can be perfectly conducted even after the memory enable signal ($M_e$) has gone down.

**Claims**

1. A power source device (3) in combination with a bubble memory unit comprising a bubble memory part (1) and a control part (2), the power source device (3) being operable to produce a supply voltage ($E_c$) for controlling the bubble memory part (1) and the control part (2) together constituting the bubble memory unit as aforesaid, a supply voltage ($E_d$) for driving the bubble memory part (1), and a memory enable signal ($M_e$) to be applied to the control part (2), the bubble memory unit being of a type in which a refresh operation can be completed even if the memory enable signal ($M_e$) has been removed, and the power source device (3) being operable on switch-on to produce voltages in the sequence $E_c, E_d, M_e$, and on switch-off to cancel them in the reverse sequence, and comprising a stabilised D.C. power source circuit (5) for producing the controlling supply voltage ($E_c$) and a switching circuit (6) for producing the driving supply voltage ($E_d$) in dependence upon the value of the controlling supply voltage ($E_c$), the stabilized D.C. power source circuit (5) employing a switching voltage regulator (53) utilizing chopping pulses and a circuit (59) for expanding a chopping pulse width in excess of its upper-limit width value during an ordinary voltage control, in circumstances such that when an input voltage value of said controlling supply voltage ($E_c$) becomes lower than a predetermined value ($E_m$), said chopping pulse width is made greater by said expanding circuit (59) than in said ordinary voltage control, thereby to provide the controlling supply voltage ($E_c$) and consequently the driving supply voltage ($E_d$) are maintained sufficiently to provide that a memory refresh operation may be properly executed after said power source device (3) for said bubble memory unit (1, 2) has been turned-off, the expanding circuit (59) being arranged to operate in dependence upon a signal from a latch circuit (71) at the output of a comparator (7) which detects the lowering of said controlling supply voltage ($E_c$) below said predetermined value ($E_m$).

2. A power source device according to claim 1, wherein the output of said latch circuit (71) is coupled to control said switching circuit (6) which produces and cancels the driving supply voltage ($E_d$) in dependence upon the comparator (7), there being a delay circuit (8) connected between the latch circuit (71) and the switching circuit (6) so that when the comparator detects that the controlling supply voltage ($E_c$) has fallen below said predetermined value ($E_m$), the latch circuit (71) issues a signal to the switching circuit (6), to cancel the driving supply voltage ($E_d$), only after a predetermined delay ($t_4$) produced by said delay circuit (8).

3. A power source device according to claim 2, and comprising a rapid discharge circuit (10) connected to the output side of said switching circuit (6) and operable to short-circuit output terminals thereof, the rapid discharge circuit (10) being connected to said delay circuit (8) to be driven thereby when the driving supply voltage ($E_d$) is cancelled.

## Patentansprüche

1. Speisespannungsgerät (3) in Kombination mit einer Blasenspeichereinheit, die aus einem Blasenspeicherteil (1) und einem Steuerteil (2) besteht, wobei das Speisespannungsgerät (3) betreibbar ist, um eine Versorgungsspannung ($E_c$) zum Steuern des Blasenspeicherteils (1) und des Steuerteils (2), die zusammen die Blasenspeichereinheit wie zuvor angegeben bilden, eine Versorgungsspannung ($E_d$) zum Treiben des Blasenspeicherteils (1) und ein Speicherfreigabesignal ($M_e$), das dem Steuerteil (2) zugeführt wird, zu erzeugen, wobei die Blasenspeichereinheit von der Art ist, bei der eine Auffrischungsoperation selbst dann vollständig ausgeführt werden kann, wenn das Speicherfreigabesignal ($M_e$) abgetrennt worden ist, und wobei das Speisespannungsgerät (3) auf seine Einschaltung hin derart betreibbar ist, daß es die Spannungen in der Reihenfolge $E_c$, $E_d$, $M_e$ erzeugt und diese auf seine Ausschaltung hin in der umgekehrten Reihenfolge löscht mit einer stabilisierten Gleichstromquellenschaltung (5) zum Erzeugen der steuernden Versorgungsspannung ($E_c$) sowie einer Schalteinrichtung (6) zum Erzeugen der treibenden Versorgungsspannung ($E_d$) in Abhängigkeit von dem Wert der steuernden Versorgungsspannung ($E_c$), wobei die stabilisierte Gleichstromquellenschaltung (5) einen Schaltspannungsregler (53), der Zerhackerimpulse verwendet, und eine Schaltung (59) benutzt, die zum Dehnen einer Zerhackerimpulsbreite über deren oberen Grenzbreitenwert hinaus während einer gewöhnlichen Spannungssteuerung unter Umständen derart dient, daß wenn ein Ausgangsspannungswert niedriger als ein vorbestimmter Wert ($E_m$) wird, die Zerhackerimpulsbreite durch die dehnende Schaltung (59) größer als bei der gewöhnlichen Spannungssteuerung gemacht wird, um dadurch zu erreichen, daß die steuernde Versorgungsspannung ($E_c$) und demzufolge die treibende Versorgungsspannung ($E_d$) in ausreichendem Ausmaß aufrechterhalten werden, um zu erreichen, daß eine Speicher-Auffrischungsoperation einwandfrei ausgeführt werden kann, nachdem das Speisespannungsgerät (3) für die Blasenspeichereinheit (1, 2) ausgeschaltet worden ist, und wobei die dehnende Schaltung (59) derart beschaffen ist, daß sie in Abhängigkeit von einem Signal aus einer Halteschaltung (71) an dem Ausgang eines Komparators (7) arbeitet, der das Absinken der

steuernden Versorgungsspannung ($E_c$) unter den vorbestimmten Wert ($E_m$) erfaßt.

2. Speisespannungsgerät nach Anspruch 1, bei dem der Ausgang der Halteschaltung (71) derart angeschlossen ist, daß diese die Schalteinrichtung (6) steuert, die die treibende Versorgungsspannung ($E_d$) in Abhängigkeit von dem Komparator (7) erzeugt und löscht, wobei eine Verzögerungsschaltung (8) zwischen die Halteschaltung (71) und die Schalteinrichtung (6) geschaltet ist, so daß wenn der Komparator erfaßt, daß die steuernde Versorgungsspannung ($E_c$) unter den vorbestimmten Wert ($E_m$) gefallen ist, die Halteschaltung (71) ein Signal an die Schalteinrichtung (6) zum Löschen der treibenden Versorgungsspannung ($E_d$), nur nach einer durch die Verzögerungsschaltung (8) erzeugten vorbestimmten Verzögerung ($t_4$) abgibt.

3. Speisespannungsgerät nach Anspruch 2, das ferner eine Schnellentladeschaltung (10) aufweist, die mit der Ausgangsseite der Schalteinrichtung (6) verbunden ist und zum Kurzschließen deren Ausgangsanschlüsse betätigbar ist, wobei die Schnellentladeschaltung (10) mit der Verzögerungsschaltung (8) zwecks Ansteuerung durch diese verbunden ist, wenn die treibende Versorgungsspannung ($E_d$) gelöscht ist.

## Revendications

1. Une source d'énergie électrique (3) en combinaison avec une unité de mémoire à bulles comprenant une partie de mémoire à bulles (1) et une partie de commande (2), la source d'énergie électrique (3) étant utilisable pour produire une tension d'alimentation ($E_c$) pour commander la partie de mémoire à bulles (1) et la partie de commande (2) ensemble constituant l'unité de mémoire à bulles comme dit plus haut, une tension d'alimentation ($E_d$) pour attaquer la partie de mémoire à bulles (1) et un signal d'habilitation de mémoire ($M_e$) à appliquer à la partie de commande (2), l'unité de mémoire à bulles étant d'un type dans lequel une opération de rafraîchissement peut être accomplie même si le signal d'habilitation de mémoire ($M_e$) a été supprimé et la source d'énergie électrique (3) étant utilisable lors du branchement pour produire des tensions dans l'ordre $E_c$, $E_d$, $M_e$ et lors du débranchement, pour les annuler dans l'ordre inverse, et comprenant un circuit stabilisé de source d'énergie électrique de courant continu (5) pour produire la tension d'alimentation de commande ($E_c$) et un circuit de commutation (6) pour produire la tension d'alimentation d'attaque ($E_d$) sous la dépendance de la valeur de la tension d'alimentation de commande ($E_c$), le circuit stabilisé de source d'énergie électrique de courant continu (5) employant un régulateur de tension de commutation (53) utilisant des impulsions de hachage et un circuit (59) servant à augmenter une largeur d'impulsion de hachage au-delà de sa valeur limite supérieure de largeur pendant une commande ordinaire de tension, dans des circonstances telles que lorsqu'une valeur de tension de sortie de ladite tension d'alimentation de commande ($E_o$) devient inférieure à une valeur prédéterminée ($E_m$), la largeur d'impulsion de hachage est rendue plus grande par le circuit d'élargissement (59) que dans la commande ordinaire de tension, de manière à assurer que la tension d'alimentation de commande ($E_o$) et par conséquent la tension d'alimentation d'attaque ($E_d$) sont maintenues suffisamment pour assurer qu'une opération de rafraîchissement de mémoire puisse être convenablement exécutée une fois que la source d'énergie électrique (3) de l'unité de mémoire à bulles (1, 2) a été coupée, le circuit d'élargissement (59) étant conçu pour fonctionner sous la dépendance d'un signal venant d'un circuit de verrouillage (71) à la sortie d'un comparateur (7) qui détecte l'abaissement de la tension d'alimentation de commande ($E_o$) en dessous de la valeur prédéterminée ($E_m$).

2. Une source d'énergie électrique selon la revendication 1, dans laquelle la sortie du circuit de verrouillage (71) est couplée de manière à commander le circuit de commutation (6) qui produit et annule la tension d'alimentation d'attaque ($E_d$) sous la dépendance de comparateur (7), un circuit de retard (8) étant relié entre le circuit de verrouillage (71) et le circuit de commutation (6) de sorte que, lorsque le comparateur détecte que la tension d'alimentation de commande ($E_o$) est tombée en dessous de la valeur prédéterminée ($E_m$), le circuit de verrouillage (71) transmet un signal au circuit de commutation (6) pour annuler la tension d'alimentation d'attaque ($E_d$) seulement au bout d'un retard prédéterminé ($t_4$) produit par le circuit de retard (8).

3. Une source d'énergie électrique selon la revendication 2, et comprenant un circuit de décharge rapide (10) relié au côté de sortie du circuit de commutation (6) et utilisable pour court-circuiter les bornes de sortie de celui-ci, le circuit de décharge rapide (10) étant relié au circuit de retard (8) de manière à être attaqué par celui-ci quand la tension d'alimentation d'attaque ($E_d$) est annulée.

# Fig . 1

# Fig . 2

Fig.3

0 046 013

# Fig. 4

# Fig. 5